# EUROPEAN PATENT APPLICATION

(11) **EP 1 641 027 A2**
(43) Date of publication of application: **29.03.2006**
(21) Application number: 05255706.3
(22) Date of filing: 14.09.2005
(51) Int. Cl.: H01L 21/00, B81C 1/00, G02B 26/08

(54) **Portable etch chamber**

(30) Priority: 27.09.2004 US 613417 P; 28.01.2005 US 45588
(71) Applicant: IDC, LLC, San Francisco, CA 94107 (US)
(72) Inventor: Cummings, William J., Millbrae California 94030 (US); Arbuckle, Brian W., Danville California 94526 (US); Floyd, Philip D., Redwood City California 94062 (US)
(74) Representative: Dunlop, Hugh Christopher

(57) **Abstract**

An etching chamber is configured to support a MEMS substrate within the chamber. The etching chamber is configured to be relatively easy to move and attach to an etch station that includes a source of vapor or gaseous etchant, a source of purge gas and/or a vacuum source. The portable etching chamber may facilitate a process for etching the MEMS substrate contained therein. For example, a MEMS substrate in such an etching chamber may be etched by connecting the chamber into an etch station and exposing the MEMS substrate to an etchant in order to etch the MEMS substrate. The substrate can be moved to or from the etch station within the portable etching chamber. In preferred embodiments, the MEMS substrate is an interferometric modulator and the etchant is XeF₂.

## Description

### Background

### Field of the Invention

This invention relates to systems and methods for etching chambers and methods for using them, particularly to etch microelectromechanical system ("MEMS") substrates such as interferometric modulator substrates.

### Description of the Related Art

Many MEMS are fabricated using methods and systems that in some ways are similar to those originally developed for use in semiconductor manufacturing. Semiconductor fabrication process flows typically involve applying numerous individual process steps such as cleaning, heating, cooling, deposition, photolithography, masking, etching, etc., to a semiconductor substrate. Many of the process steps are conducted at separate process stations that are physically separated from one another in the fabrication facility. The substrates are typically moved between process stations using a carry case (often referred to as a "substrate carrier," "cassette" or "pod", e.g., Front Opening Unified Pod or "FOUP" for silicon wafers used in the integrated circuit fabrication industry).

A spatial light modulator is an example of a MEMS. A variety of different types of spatial light modulators can be used for imaging applications. One type of a spatial light modulator is an interferometric modulator. Interferometric modulator devices can be arranged in an array configuration to provide a display assembly having advantageous operational and performance characteristics. For example, these displays may have rich color characteristics as well as low power consumption.

Interferometric modulator devices operate by reflecting light and producing optical interference. Interferometric modulators have at least two states that provide corresponding different appearances to a viewer. In one state, a relatively narrow band reflection may present a distinct color to the viewer, such as a red, green, or blue color. In another state, the interferometric modulator can act on the incident light so as to present a reflected dark or black appearance to a viewer.

### Summary

The system, method, and devices described herein each have several aspects, no single one of which is solely responsible for its desirable attributes. Without limiting the scope of this invention, its more prominent features will now be discussed briefly. After considering this discussion, and particularly after reading the section entitled "Detailed Description of Certain Embodiments" one will understand how the features of systems, methods and devices described herein provide advantages that include, for example, improved throughput, control and process flexibility.

An embodiment provides a portable XeF₂ etching chamber that includes a sealable container having an inlet configured for attachment to a vacuum source and a holder configured to support at least one MEMS substrate within the sealable container during movement of the sealable container. The sealable container is configured to facilitate movement relative to the vacuum source.

Another embodiment provides a XeF₂ etching system that includes a means for etching (such as an etch station) and a means for containing (such as a sealable container). The means for etching includes at least one source selected from a XeF₂ vapor source, a vacuum source and a purge gas source. The means for containing includes means for attaching the means for containing to the at least one source and means for supporting the at least one MEMS substrate within the means for containing during movement of the means for containing. The means for containing is configured to detach from the at least one source and configured to facilitate movement relative to the at least one source.

Another embodiment provides a XeF₂ etching system that includes an etch station comprising at least one source selected from a XeF₂ vapor source, a vacuum source and a purge gas source, a sealable container comprising an inlet configured to attach to the at least one source and a holder configured to support at least on MEMS substrate within the sealable container during movement of the sealable container. The sealable container is configured to detach from the at least one source and configured to facilitate movement relative to the at least one source.

Another embodiment provides a portable XeF₂ etching chamber that includes sealable means for containing XeF₂ vapor and means for holding at least one MEMS substrate to facilitate etching of the MEMS substrate by the XeF₂ vapor. The sealable means may comprise a sealable container configured for attachment to at least one source, such as a XeF₂ vapor source, a vacuum source and/or a purge gas source. The means for holding at least one MEMS substrate may comprise a holder configured to support the at least one MEMS substrate within the sealable means during movement of the sealable means.

Another embodiment provides a method for etching a MEMS substrate that includes moving a portable etching chamber to a location in operable proximity to a source of etchant and attaching the portable etching chamber to the source of etchant. A MEMS substrate is supported within the portable etching chamber and is exposed to the etchant for a period of time that is effective to etch the MEMS substrate to form a released MEMS substrate. The portable etching chamber is detached from the source of etchant, moved away from the source of etchant, and the released MEMS substrate is unloaded from the portable etching chamber.

Another embodiment provides a method for etching a MEMS substrate that includes inserting a MEMS substrate into a portable etching chamber and moving the portable etching chamber having the MEMS substrate housed therein to a location in operable proximity to an etch station. The portable etching chamber is connected to the etch station and the MEMS substrate is etched within the portable chamber while the portable etching chamber is attached to the etch station.

Another embodiment provides a portable XeF₂ etching chamber that includes a sealable container and a holder configured to support at least one MEMS substrate within the sealable container during movement of the container. The sealable container includes an inlet configured for attachment to at least one source, the source being selected from a XeF₂ vapor source, a vacuum source and a purge gas source. The sealable container is configured to facilitate movement relative to at least one source.

Another embodiment provides an etching system comprising means for containing a MEMS substrate comprising a means for supporting at least one MEMS substrate within the containing means during movement of the containing means. The system further comprises means for attaching the containing means to at least one source selected from a XeF2 vapor source, a vacuum source and a purge gas source, the containing means being configured to detach from the at least one source and being configured to facilitate movement relative to the at least one source.

These and other embodiments are described in greater detail below.

### Brief Description of the Drawings

These and other aspects of the invention will be readily apparent from the following description and from the appended drawings (not to scale), which are meant to illustrate and not to limit the invention, and wherein:
Figure 1 is an isometric view depicting a portion of one embodiment of an interferometric modulator display in which a movable reflective layer of a first interferometric modulator is in a released position and a movable reflective layer of a second interferometric modulator is in an actuated position.
Figure 2 is a system block diagram illustrating one embodiment of an electronic device incorporating a 3x3 interferometric modulator display.
Figure 3 is a diagram of movable mirror position versus applied voltage for one exemplary embodiment of an interferometric modulator of Figure 1.
Figure 4 is an illustration of a set of row and column voltages that may be used to drive an interferometric modulator display.
Figures 5A and 5B illustrate one exemplary timing diagram for row and column signals that may be used to write a frame of display data to the 3x3 interferometric modulator display of Figure 2.
Figure 6A is a cross section of the device of Figure 1.
Figure 6B is a cross section of an alternative embodiment of an interferometric modulator.
Figure 6C is a cross section of another alternative embodiment of an interferometric modulator.
Figure 7 is a perspective view illustrating a sealable container 700.
Figure 8 is a side view of the sealable container illustrated in Figure 7.
Figure 9 is a schematic diagram illustrating various features of a XeF₂ etching system 900.
Figures 10A and 10B schematically illustrate sealable containers configured to facilitate observation of a MEMS substrate from the exteriors of the containers.
Figure 11 schematically illustrates various features of a XeF₂ etching system.
Figure 12 illustrates various steps in a method for etching a MEMS substrate.

### Detailed Description of Preferred Embodiments

As described more fully below, in preferred embodiments an etching chamber is configured to support a MEMS substrate within the chamber. The etching chamber is configured to be relatively easy to move and attach to an etching station containing one or more of various components common to etching tools, such as a vacuum pump, inert gas source, and/or etchant source. This portable etching chamber may facilitate a process for etching a MEMS substrate contained therein. For example, a MEMS substrate in such an etching chamber may be etched by moving the etching chamber to an etch station, connecting the chamber to piping for the etchant, purge gas and/or vacuum pump, and exposing the MEMS substrate to the etchant in order to etch the MEMS substrate.

As will be apparent from the following description, preferred embodiments may be implemented in various processes for making any device that is configured to display an image, whether in motion (e.g., video) or stationary (e.g., still image), and whether textual or pictorial. More particularly, it is contemplated that the embodiments may be implemented in various processes for making a variety of electronic devices such as, but not limited to, mobile telephones, wireless devices, personal data assistants (PDAs), hand-held or portable computers, GPS receivers/navigators, cameras, MP3 players, camcorders, game consoles, wrist watches, clocks, calculators, television monitors, flat panel displays, computer monitors, auto displays (e.g., odometer display, etc.), cockpit controls and/or displays, display of camera views (e.g., display of a rear view camera in a vehicle), electronic photographs, electronic billboards or signs, projectors, architectural structures (e.g., tile layouts), packaging, and aesthetic structures (e.g., display of images on a piece of jewelry). More generally, the embodiments may be implemented in various processes for making electronic switching devices.

The following detailed description is directed to certain specific embodiments of the invention. However, the invention can be embodied in a multitude of different ways. In this description, reference is made to the drawings wherein like parts are designated with like numerals throughout.

Certain embodiments are directed to portable or removable etching chambers and methods for using the portable etching chambers for the manufacture of MEMS. As noted above, many MEMS are fabricated using methods and systems that in some ways are similar to those originally developed for use in semiconductor manufacturing. MEMS typically contain moving parts, and thus the process for making such MEMS typically involves forming a cavity (typically characterized by an overlying or overhanging moving part) in a MEMS substrate by removing or "etching" a previously formed layer. The previously formed layer that is removed by etching is often referred to as a "sacrificial" layer. Etching is typically conducted by exposing the sacrificial layer to an "etchant" that selectively removes the sacrificial layer with minimum damage to the other components of the MEMS. As used herein, the term "MEMS substrate" refers to the substrate on which a MEMS device is fabricated. The MEMS substrate may contain one or, preferably, multiple MEMS that are in the process of being fabricated, and thus the MEMS on the MEMS substrate may be wholly or partly inoperative. Prior to removal of the sacrificial layer, the MEMS, MEMS substrate or component thereof may be referred to as being "unreleased." After removal, the MEMS, MEMS substrate or component thereof may be referred to as being "released."

This invention is not bound by theory, but it is believed that a chemical reaction between the etchant (or components of the etchant) with the sacrificial layer (or components of the sacrificial layer) is involved in the release of the MEMS. Liquid etchants may be used, but gaseous or vaporous etchants are often preferred. Likewise, the product of the reaction is preferably a liquid or, more preferably, a gas that may be easily removed from the MEMS substrate. Preferably, both the etchant and the product formed by the chemical reaction between the etchant and the sacrificial layer are gases.

It has been found that xenon difluoride (XeF₂) vapor etches a number of materials, and that the etching rate varies from material to material. For example, at 23°C and 3.8 Torr, it has been found that the etching rate of XeF₂ vapor is significantly higher for etching amorphous silicon (about 350 Å per second) than molybdenum (about 45 Å per second), and that the etching rate is very low (close to zero under these conditions) for indium tin oxide, aluminum, nickel, chromium, aluminum oxide, and silicon oxide. At 23°C and 2.6 Torr, the XeF₂ vapor etching rate decreased in the order tungsten (about 13 Å per second) > titanium (about 5 Å per second) > silicon nitride (SiNₓ) (about 2 Å per minute). Thus, XeF₂ vapor may serve as a selective etchant for the fabrication of microelectromechanical systems (MEMS). For example, silicon or molybdenum may be selectively etched from MEMS substrates, with little or no etching of other materials such as indium tin oxide, aluminum, nickel, chromium, aluminum oxide, and silicon oxide. The relative etching rates of silicon versus one or more of indium tin oxide, aluminum, nickel, chromium, aluminum oxide, or silicon oxide ("XeF₂ selectivity ratio") is typically at least about 10, and may be at least about 50 or at least about 100. The XeF₂ selectivity ratio for molybdenum versus indium tin oxide, aluminum, nickel, chromium, aluminum oxide, or silicon oxide is typically at least about 5 and may be at least about 10.

XeF₂ is a solid compound that sublimes at its vapor pressure (3.8 Torr) at room temperature. This invention is not bound by theory, but it is believed that XeF₂ at least partially dissociates in the vapor phase to produce Xe and F₂. The vapor formed by XeF₂ sublimation (which may include products of XeF₂ dissociation) will be referred to herein as XeF₂ or XeF₂ vapor; the solid form will be referred to as solid XeF₂. Certain embodiments described below are illustrated by using XeF₂ as an etchant in the context of fabricating a preferred class of MEMS devices known as interferometric modulators. However, those skilled in the art will appreciate that the invention is applicable to other etchants and MEMS devices as well.

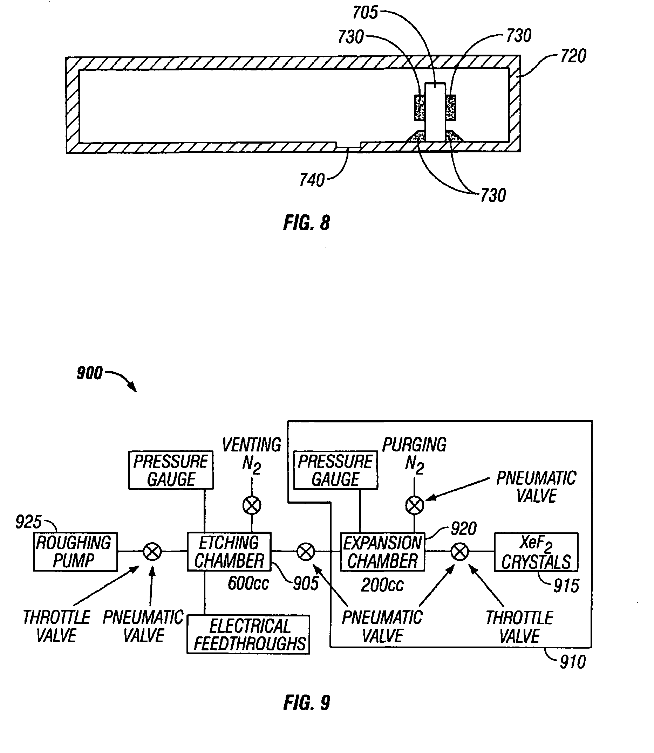

Systems for providing XeF₂ vapor are commercially available from Xactix (U.S.A.) and Penta Vacuum (Singapore). The features typically included in such systems include an etching chamber that is attached to a gas handling system as schematically illustrated in Figure 9. It has been found that such systems may be used for the fabrication of MEMS, e.g., by placing a MEMS substrate into the etching chamber and exposing it to XeF₂ vapor. In particular, it has been found that XeF₂ is a preferred etchant for the fabrication of interferometric modulators.

Spatial light modulators used for imaging applications come in many different forms. Transmissive liquid crystal display (LCD) modulators modulate light by controlling the twist and/or alignment of crystalline materials to block or pass light. Reflective spatial light modulators exploit various physical effects to control the amount of light reflected to the imaging surface. Examples of such reflective modulators include reflective LCDs, and digital micromirror devices.

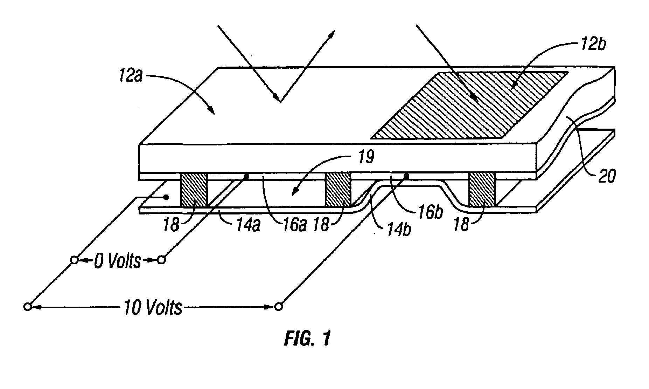

Another example of a spatial light modulator is an interferometric modulator that modulates light by interference. One interferometric modulator display embodiment comprising an interferometric MEMS display element is illustrated in Figure 1. In these devices, the pixels are in either a bright or dark state. In the bright ("on" or "open") state, the display element reflects a large portion of incident visible light to a user. When in the dark ("off" or "closed") state, the display element reflects little incident visible light to the user. Depending on the embodiment, the light reflectance properties of the "on" and "off" states may be reversed. MEMS pixels can be configured to reflect predominantly at selected colors, allowing for a color display in addition to black and white.

Figure I is an isometric view depicting two adjacent pixels in a series of pixels of a visual display, wherein each pixel comprises a MEMS interferometric modulator. In some embodiments, an interferometric modulator display comprises a row/column array of these interferometric modulators. Each interferometric modulator includes a pair of reflective layers positioned at a variable and controllable distance from each other to form a resonant optical cavity with at least one variable dimension. In one embodiment, one of the reflective layers may be moved between two positions. In the first position, referred to herein as the released state, the movable layer is positioned at a relatively large distance from a fixed partially reflective layer. In the second position, the movable layer is positioned more closely adjacent to the partially reflective layer. Incident light that reflects from the two layers interferes constructively or destructively depending on the position of the movable reflective layer, producing either an overall reflective or non-reflective state for each pixel.

The depicted portion of the pixel array in Figure I includes two adjacent interferometric modulators **12a** and **12b.** In the interferometric modulator **12a** on the left, a movable and highly reflective layer **14a** is illustrated in a released position at a predetermined distance from a fixed partially reflective layer **16a.** In the interferometric modulator **12b** on the right, the movable highly reflective layer **14b** is illustrated in an actuated position adjacent to the fixed partially reflective layer **16b.**

The fixed layers **16a, 16b** are electrically conductive, partially transparent and partially reflective, and may be fabricated, for example, by depositing one or more layers each of chromium and indium-tin-oxide onto a transparent substrate **20.** The layers are patterned into parallel strips, and may form row electrodes in a display device as described further below. The movable layers **14a, 14b** may be formed as a series of parallel strips of a deposited metal layer or layers (orthogonal to the row electrodes **16a, 16b)** deposited on top of posts **18** and an intervening sacrificial material deposited between the posts **18.** When the sacrificial material is etched away, the deformable metal layers are separated from the fixed metal layers by a defined air gap **19.** A highly conductive and reflective material such as aluminum may be used for the deformable layers, and these strips may form column electrodes in a display device.

With no applied voltage, the cavity **19** remains between the layers **14a, 16a** and the deformable layer is in a mechanically relaxed state as illustrated by the pixel **12a** in Figure 1. However, when a potential difference is applied to a selected row and column, the capacitor formed at the intersection of the row and column electrodes at the corresponding pixel becomes charged, and electrostatic forces pull the electrodes together. If the voltage is high enough, the movable layer is deformed and is forced against the fixed layer (a dielectric material which is not illustrated in this Figure may be deposited on the fixed layer to prevent shorting and control the separation distance) as illustrated by the pixel **12b** on the right in Figure 1. The behavior is the same regardless of the polarity of the applied potential difference. In this way, row/column actuation that can control the reflective vs. non-reflective pixel states is analogous in many ways to that used in conventional LCD and other display technologies.

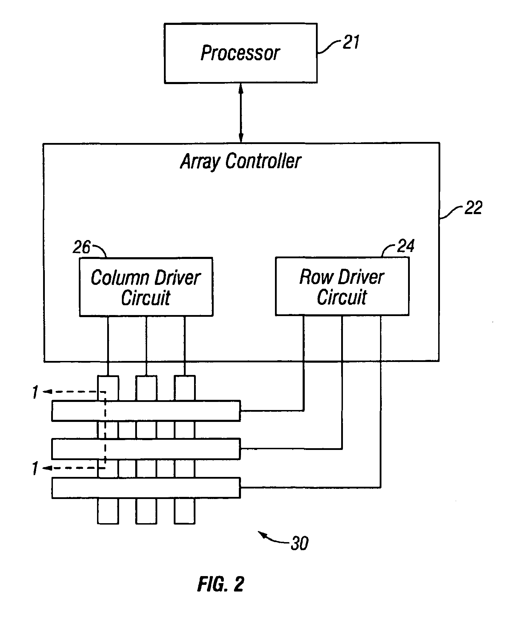

Figures 2 through 5 illustrate one exemplary process and system for using an array of interferometric modulators in a display application. Figure 2 is a system block diagram illustrating one embodiment of an electronic device that may incorporate aspects of the invention. In the exemplary embodiment, the electronic device includes a processor **21** which may be any general purpose single- or multi-chip microprocessor such as an ARM, Pentium® , Pentium II® , Pentium III® , Pentium IV® , Pentium® Pro, an 8051, a MIPS® , a Power PC® , an ALPHA® , or any special purpose microprocessor such as a digital signal processor, microcontroller, or a programmable gate array. As is conventional in the art, the processor **21** may be configured to execute one or more software modules. In addition to executing an operating system, the processor may be configured to execute one or more software applications, including a web browser, a telephone application, an email program, or any other software application.

In one embodiment, the processor **21** is also configured to communicate with an array controller **22.** In one embodiment, the array controller **22** includes a row driver circuit **24** and a column driver circuit **26** that provide signals to a pixel array 30. The cross section of the array illustrated in Figure 1 is shown by the lines 1-1 in Figure 2.

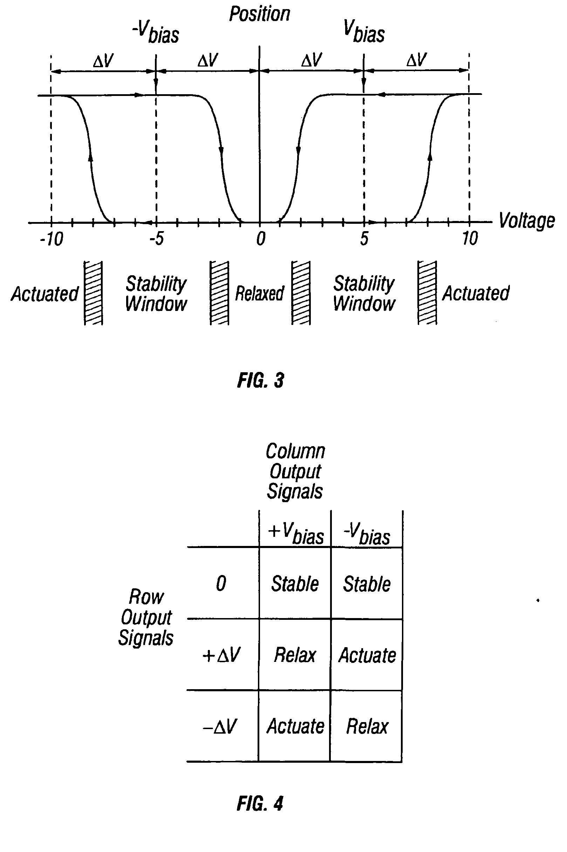

For MEMS interferometric modulators, the row/column actuation protocol may take advantage of a hysteresis property of these devices illustrated in Figure 3. It may require, for example, a 10 volt potential difference to cause a movable layer to deform from the released state to the actuated state. However, when the voltage is reduced from that value, the movable layer maintains its state as the voltage drops back below 10 volts. In the exemplary embodiment of Figure 3, the movable layer does not release completely until the voltage drops below 2 volts. There is thus a range of voltage, about 3 to 7 V in the example illustrated in Figure 3, where there exists a window of applied voltage within which the device is stable in either the released or actuated state. This is referred to herein as the "hysteresis window" or "stability window." For a display array having the hysteresis characteristics of Figure 3, the row/column actuation protocol can be designed such that during row strobing, pixels in the strobed row that are to be actuated are exposed to a voltage difference of about 10 volts, and pixels that are to be released are exposed to a voltage difference of close to zero volts. After the strobe, the pixels are exposed to a steady state voltage difference of about 5 volts such that they remain in whatever state the row strobe put them in. After being written, each pixel sees a potential difference within the "stability window" of 3-7 volts in this example. This feature makes the pixel design illustrated in Figure 1 stable under the same applied voltage conditions in either an actuated or released pre-existing state. Since each pixel of the interferometric modulator, whether in the actuated or released state, is essentially a capacitor formed by the fixed and moving reflective layers, this stable state can be held at a voltage within the hysteresis window with almost no power dissipation. Essentially no current flows into the pixel if the applied potential is fixed.

In typical applications, a display frame may be created by asserting the set of column electrodes in accordance with the desired set of actuated pixels in the first row. A row pulse is then applied to the row 1 electrode, actuating the pixels corresponding to the asserted column lines. The asserted set of column electrodes is then changed to correspond to the desired set of actuated pixels in the second row. A pulse is then applied to the row 2 electrode, actuating the appropriate pixels in row 2 in accordance with the asserted column electrodes. The row 1 pixels are unaffected by the row 2 pulse, and remain in the state they were set to during the row 1 pulse. This may be repeated for the entire series of rows in a sequential fashion to produce the frame. Generally, the frames are refreshed and/or updated with new display data by continually repeating this process at some desired number of frames per second. A wide variety of protocols for driving row and column electrodes of pixel arrays to produce display frames are also well known and may be used in conjunction with the present invention.

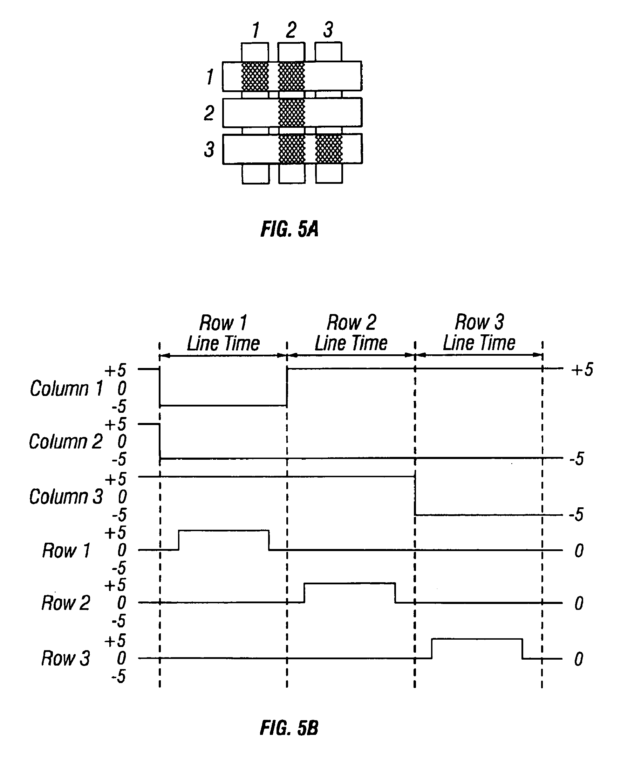

Figures 4 and 5 illustrate one possible actuation protocol for creating a display frame on the 3x3 array of Figure 2. Figure 4 illustrates a possible set of column and row voltage levels that may be used for pixels exhibiting the hysteresis curves of Figure 3. In the Figure 4 embodiment, actuating a pixel involves setting the appropriate column to-V_{bias}, and the appropriate row to +ΔV, which may correspond to -5 volts and +5 volts respectively Releasing the pixel is accomplished by setting the appropriate column to +V_{bias}, and the appropriate row to the same +ΔV, producing a zero volt potential difference across the pixel. In those rows where the row voltage is held at zero volts, the pixels are stable in whatever state they were originally in, regardless of whether the column is at +V_{bias}, or -V_{bias}.

Figure 5B is a timing diagram showing a series of row and column signals applied to the 3x3 array of Figure 2 which will result in the display arrangement illustrated in Figure 5A, where actuated pixels are non-reflective. Prior to writing the frame illustrated in Figure 5A, the pixels can be in any state, and in this example, all the rows are at 0 volts, and all the columns are at +5 volts. With these applied voltages, all pixels are stable in their existing actuated or released states.

In the Figure 5A frame, pixels (1,1), (1,2), (2,2), (3,2) and (3,3) are actuated. To accomplish this, during a "line time" for row 1, columns 1 and 2 are set to-5 volts, and column 3 is set to +5 volts. This does not change the state of any pixels, because all the pixels remain in the 3-7 volt stability window. Row 1 is then strobed with a pulse that goes from 0, up to 5 volts, and back to zero. This actuates the (1,1) and (1,2) pixels and releases the (1,3) pixel. No other pixels in the array are affected. To set row 2 as desired, column 2 is set to -5 volts, and columns 1 and 3 are set to +5 volts. The same strobe applied to row 2 will then actuate pixel (2,2) and release pixels (2,1) and (2,3). Again, no other pixels of the array are affected. Row 3 is similarly set by setting columns 2 and 3 to -5 volts, and column 1 to +5 volts. The row 3 strobe sets the row 3 pixels as shown in Figure 5A. After writing the frame, the row potentials are zero, and the column potentials can remain at either +5 or -5 volts, and the display is then stable in the arrangement of Figure 5A. It will be appreciated that the same procedure can be employed for arrays of dozens or hundreds of rows and columns. It will also be appreciated that the timing, sequence, and levels of voltages used to perform row and column actuation can be varied widely within the general principles outlined above, and the above example is exemplary only, and any actuation voltage method can be used with the present invention.

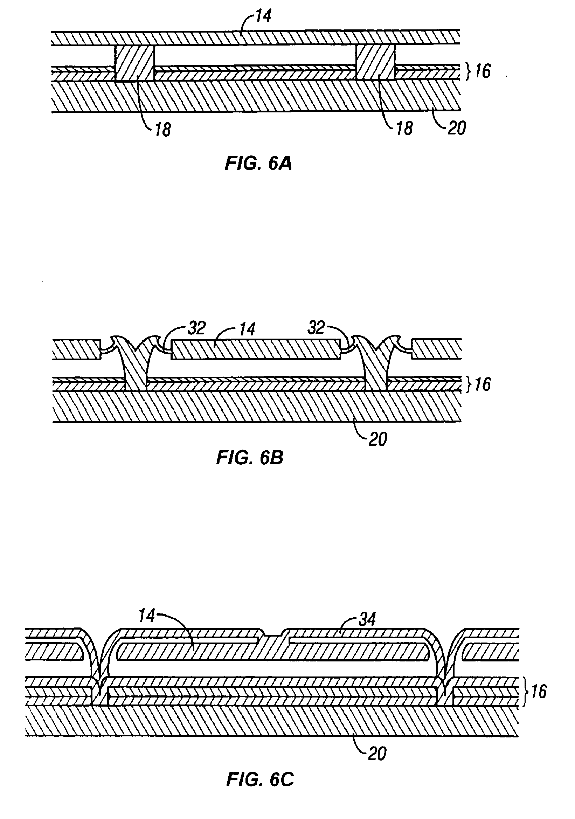

The details of the structure of interferometric modulators that operate in accordance with the principles set forth above may vary widely. For example, Figures 6A-6C illustrate three different embodiments of the moving mirror structure. Figure 6A is a cross section of the embodiment of Figure 1, where a strip of metal material **14** is deposited on orthogonally extending supports **18.** In Figure **6B,** the moveable reflective material **14** is attached to supports at the corners only, on tethers **32.** In Figure 6C, the moveable reflective material **14** is suspended from a deformable layer **34.** This embodiment has benefits because the structural design and materials used for the reflective material **14** can be optimized with respect to the optical properties, and the structural design and materials used for the deformable layer **34** can be optimized with respect to desired mechanical properties. The production of various types of interferometric devices is described in a variety of published documents, including, for example, U.S. Published Application 2004/0051929. A wide variety of well known techniques may be used to produce the above described structures involving a series of material deposition, patterning, and etching steps.

The term "interferometric modulator substrate" may be used herein to refer to a substrate on which an interferometric modulator is fabricated, and thus the interferometric modulator on an interferometric modulator substrate may be wholly or partly inoperative. Manufacture of an interferometric modulator typically involves performing a series of fabrication steps (e.g., deposition, masking and etching steps) on an interferometric modulator substrate. For example, fabrication of the interferometric modulator illustrated in Figure 6A typically includes forming a first mirror **14** on a substrate **20,** then depositing a sacrificial layer over the substrate **20.** Openings are then formed in the sacrificial layer and posts **18** are formed in the openings. After formation of the second mirror 16, the sacrificial layer is removed by etching to form the optical cavity **19.** Other process flows for making interferometric modulators also involve forming a sacrificial layer, then later removing it by exposing the sacrificial layer to a gaseous etchant (such as XeF₂) to form an optical cavity, see, e.g., U.S. Patent Application Publication No. 2004/0051929. In this context, the removal of the sacrificial layer "releases" the movable mirror and thus may be referred to herein as a "release" etch.

As discussed above, conventional fabrication process flows typically involve moving substrates from one fixed station to another using a carrier, e.g. a cassette. Although the use of such carriers may entail numerous carrier loading and unloading steps during fabrication, on balance such use is generally considered desirable in semiconductor fabrication flows.

It has now been found, however, that conventional process flows are not particularly well-suited for the fabrication of MEMS such as interferometric modulators. For example, existing process flows generally involve loading an unprocessed or partially fabricated substrate into a carrier, transporting the substrate to a processing station, unloading the substrate from the carrier and loading it into the processing station, processing the substrate, unloading the processed substrate from the processing station and loading it back into a carrier, then transporting the processed substrate to the next processing step. As another example, the preferred interferometric modulator substrates have interior cavities or openings that may be difficult to clean by conventional methods. Loading and unloading such substrates in conventional carriers undesirably increases the risk of substrate contamination. In addition, conventional carriers are not particularly well-suited for storing MEMS devices.

Furthermore, in some situations transportation of released MEMS substrates may be difficult because of the risk of exposing microscopic mechanical parts to the environment. Movement of such MEMS substrates is preferably minimized to prevent or reduce damage to the MEMS substrate from mechanical shock and from particles, abrasives, or other environmental hazards. It has been found that safe transport of released MEMS substrates is facilitated by providing a chamber that protects the substrates from one or more such potential hazards, e.g., mechanical shock, water vapor and/or particulate contaminants. A preferred embodiment provides a mechanically enclosed chamber in which the MEMS substrate can be etched and released. The chamber may be sealed and moved a short distance (1-10 m) or a much longer distance (1000's of meters), protecting the MEMS substrates from mechanical damage and/or from atmospheric hazards such as water vapor and/or particulates.

Portable etching chambers, systems and methods have now been developed that are well-suited for the fabrication of MEMS such as interferometric modulators. One embodiment provides a portable XeF₂ etching chamber configured for attachment to a source of XeF₂ vapor, the XeF₂ etching chamber being further configured to contain at least one MEMS substrate within the sealable container during movement of the container. In certain embodiments, the portable XeF₂ etching chamber comprises a sealable container comprising an inlet configured for attachment to a source of XeF₂ vapor and a holder configured to support at least one MEMS substrate within the sealable container. The sealable container is configured to facilitate movement relative to other major components of the system, e.g., the source of XeF₂ vapor, the vacuum pump and/or the purge gas source.

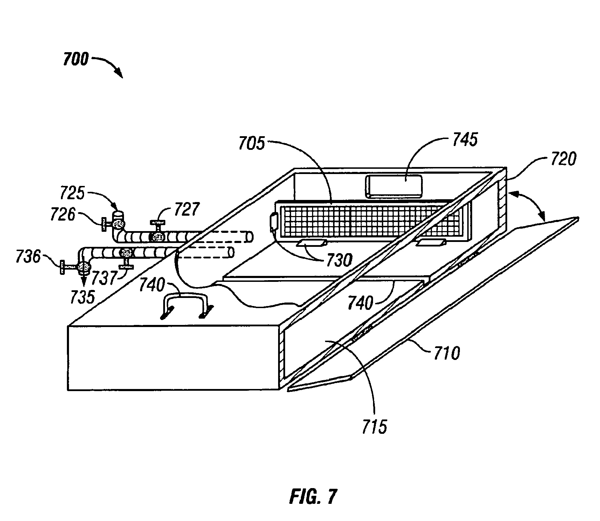

An embodiment of a portable XeF₂ etching chamber is illustrated in Figure 7. In the illustrated embodiment, a sealable container **700** is constructed from a material such as metal, plastic or heavy glass that is sufficiently strong to allow it to be safely evacuated down to a pressure in the range of about 10 mTorr to 50 mTorr. In the illustrated embodiment, the sealable container **700** is configured to contain an interferometric modulator substrate **705.** The sealable container **700** is equipped with a door **710** to allow the interferometric modulator **substrate 705** to be placed into the sealable container **700** and removed through an opening **715.** The container **700** is rendered sealable by pliable material **720** positioned on the container **700** along the edges of the opening **715** and configured to seal the container **700** to substantially prevent XeF₂ vapor from escaping when the door **710** is in the closed position. The pliable material **720** is preferably resistant to the etchant, e.g., resistant to degradation by XeF₂. Examples of suitable XeF₂₋resistant pliable materials include various fluorinated polymers, e.g., fluoroelastomers such as those commercially available from DuPont Dow Elastomers LLC (Wilmington, Delaware, USA) under the tradenames Teflon® and Viton®. In an alternative embodiment (not shown) pliable material is placed along the edges of the door **710** in addition to or instead of placement along the edges of the opening **715;** other sealing configurations may also be used.

The sealable container **700** also comprises an inlet **725** configured for attachment to a source of XeF₂ vapor (not shown) and a series of supports **730** on the interior walls of the sealable container **700** are configured to hold one or more MEMS substrates (such as interferometric modulator substrate **705 ―** one shown but preferably supports or slots are provided for between 1 and 20 such substrates **705)** inside the chamber In the illustrated embodiment, the supports **730** are positioned on opposite sides of the interferometric modulator substrate **705** as illustrated in the side view shown in Figure 8 (various features are omitted from Figure 8 for clarity). Other holders configured to support the MEMS substrate (such as slots **740** in the wall of the sealable container **700)** may also be used. The holders are preferably configured to allow a number of MEMS substrates to be held in the container, yet far enough apart to allow efficient etching by XeF₂ vapor flow or diffusion. Preferably, the holders are made from or lined with a XeF₂-resistant pliable material (such as those discussed above) that cushions the MEMS substrate from mechanical shock.

The portable XeF₂ etching chamber may contain a single inlet for XeF₂ vapor that also serves as an outlet (e.g., by attaching vacuum to the inlet and to decrease the pressure within, then shutting off the vacuum and opening a valve to permit XeF₂ to enter, then closing the valve and etching the substrate, then applying vacuum again to remove reaction products and any remaining XeF₂ gas through the inlet). In preferred embodiments, the XeF₂ etching chamber is equipped with a XeF₂ inlet and an exhaust outlet. For example, in the illustrated embodiment, the sealable container **700** comprises an inlet **725** and an exhaust outlet **735,** preferably configured for attachment to a vacuum pump (not shown). The XeF₂ inlet **725** and the exhaust outlet **735** are equipped with self-sealing valves **726, 736** (such as quick connect valves, commercially available) to facilitate connection to a XeF₂ source and vacuum, respectively. Self-sealing valves are preferred in order to reduce or prevent leakage of the XeF₂ when the chamber is disconnected. Manual isolation valves **727, 737** may be used in addition to or instead of the self-sealing valves to reduce or prevent etchant leakage.

In the illustrated embodiment, the sealable container **700** is equipped with a handle **740** configured to allow the sealable container **700** to be lifted and moved. In addition to or in place of the handle, the sealable container **700** may be equipped with other means (not shown) for moving the portable etching chamber such as one or more wheels e.g., a roller or caster), a substantially low-friction sliding surface, etc., and/or the sealable container **700** can be configured to be lifted robotically and transported using a manual guided vehicle ("MGV", e.g., a cart or handtruck) and/or a automated guided vehicle ("AGV").

The portable etching chamber is preferably further configured to allow attachment to a pressure gauge, electrical lines, etc. to form a XeF₂ etching system **900** in the general manner illustrated in Figure 9 (described in greater detail below). A preferred XeF₂ etching chamber contains a window **745** (Figure 7) configured to permit observation of the MEMS substrate during etching. The portable etching chamber may optionally include power connections (not shown) to facilitate quick connection and disconnection from a power source at the etch station, and/or the portable etching chamber may be optionally equipped with a battery, to provide electrical power to optional components such as the detector and heating elements described elsewhere herein.

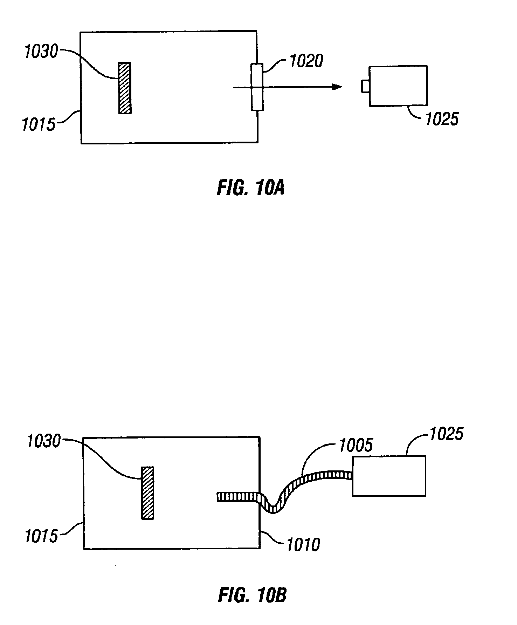

With reference to Figures 10A and 10B, the window **1020** may be constructed from a relatively transparent material such as glass, plastic or quartz and may have a relatively large size to permit direct visual observation of the interior, or may be replaced by an optical fiber **1005** (Figure 10B) or bundle of fibers (not shown) that carries light from the interior to the exterior of the chamber. Other process monitoring systems may also be used, such as a system having a detector inside the chamber that transmits that information to the exterior. A window **1020** has the advantage of simplicity and reliability. Suitable fiber optic bundles**1005** useful for observing or monitoring the MEMS substrate during etching are commercially available from, e.g., Spectra-Physics (Oriel Instruments) and from Ocean Optics, Inc. A detector **1025** may be configured to transmit or receive signals through the chamber window **1020** (Figure 10A) or may be configured to receive signals through fiber optics **1005** passing through a wall **1010** of the etching chamber **1015** to the exterior of the chamber as illustrated schematically in Figure 10B. The detector may be part of the etch station or the etch chamber, as desired. The configurations illustrated in Figure 10A and 10A facilitate observation of a MEMS substrate **1030** from the exteriors of the containers **1015.**

The XeF₂ etching chamber may be attached to other components to form a XeF₂ etching system **900** as schematically illustrated in Figure 9. In the illustrated embodiment, the XeF₂ etching system **900** comprises a portable XeF₂ etching chamber **905** (e.g., as described above), the XeF₂ etching chamber **905** being readily detachable from the other parts of the system. The illustrated embodiment **900** comprises a source **910** of XeF₂ vapor (such as a vessel **915** containing solid XeF₂ and an expansion chamber **920)** that is operably connected to the portable XeF₂ etching chamber **905;** various lines, pressure gauges and valves (e.g., to manually isolate the chamber **905** prior to disconnect) for carrying, venting, and purging XeF₂ and nitrogen (or other inert gas) throughout the system **900;** a vacuum pump **925** operably connected to the vacuum chamber **905;** and further preferably comprises a computer (not shown) operably connected to the system and programmed to control one or more stages of the etching process. Operation of the embodiment of Figure 9 involves forming XeF₂ vapor from the solid XeF₂, passage of that vapor in the expansion chamber 920, and further passage of the XeF₂ vapor into the etching chamber **905,** through the lines and valves illustrated in Figure 9. The vacuum or roughing pump **925** connected to the etching chamber **905** may be used to partially evacuate the etching chamber **905** to facilitate passage of the XeF₂ vapor. A nitrogen (N₂) purge is preferably introduced into the expansion chamber **920** and vented through the etching chamber **905** as shown in Figure 9. The nitrogen purge is used to purge XeF₂ from the system after XeF₂ etching has taken place. The purge may also be used prior to etching to establish a uniform N₂ atmosphere in the etching chamber. Other purge gases (e.g., He, Ar, Ne, etc.) and system configurations may also be used.

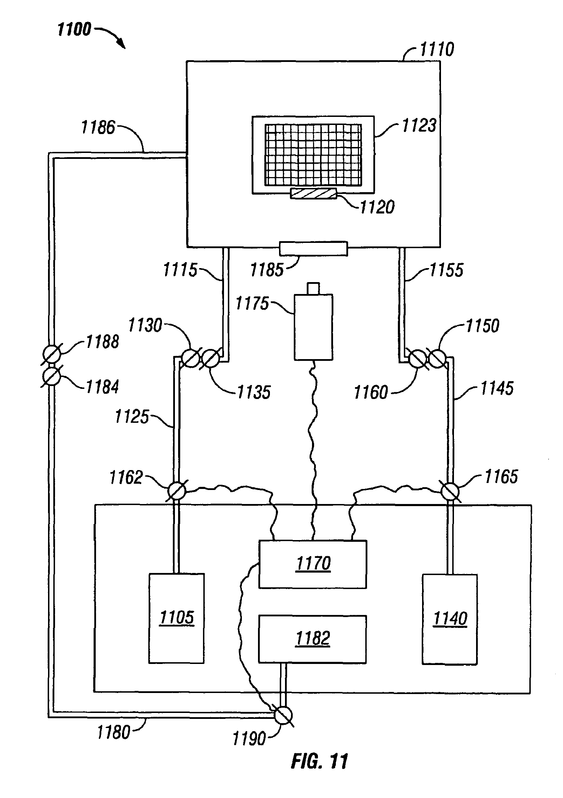

An embodiment of a XeF₂ etching system is illustrated schematically in Figure 11. The system **1100** comprises a source of XeF₂ vapor **1105** and a sealable container **1110,** the sealable container **1110** being configured for detachment from the source of XeF₂ vapor **1105** and being configured to facilitate movement relative to the source of XeF₂ vapor **1105.** The sealable container **1110** may be a portable XeF₂ etching chamber as described above. In the illustrated embodiment, the sealable container **1110** is equipped with an inlet **1115** configured for attachment to the source of XeF₂ vapor **1105** and a holder **1120** configured to support at least one MEMS substrate (such as interferometric modulator substrate **1123)** within the sealable container **1110.** Various configurations of the sealable container **1110,** the inlet **1115** and the holder **1120** are described above.

The XeF₂ etching system **1100** is also equipped with a XeF₂ feed line **1125** running from the source of XeF₂ vapor **1105** to a first quick connect valve **1130.** The XeF₂ inlet **1115** is equipped with a second quick connect valve **1135** configured to mate with the first quick connect valve **1130,** thereby facilitating detachment of the sealable container from the source of XeF₂ vapor **1105.** The XeF₂ etching system **1100** is also equipped with a vacuum pump **1140** and an exhaust line **1145** running from the vacuum pump **1140** to a third quick connect valve **1150.** The sealable container **1110** is equipped with an exhaust line **1155** equipped with a fourth quick connect valve **1160** configured to mate with the third quick connect valve **1150,** thereby further facilitating detachment of the sealable container from the vacuum pump**1140**. The XeF₂ etching system **1100** is also equipped with control valves **1162, 1165** on the XeF₂ feed and vacuum lines, respectively, that can be manipulated as desired to control the flow of the XeF₂ vapor and the evacuation of the sealable container **1110,** respectively. In the illustrated embodiment, the control valves **1162, 1165** are shown in communication with a system control computer **1170,** which can be programmed to conduct etching as described herein.

The XeF₂ etching system **1100** is also equipped with a purge line **1180** running from a source of purge gas **1182** (e.g., nitrogen) to a fifth quick connect valve **1184.** The sealable container **1110** is also equipped with a purge gas inlet **1186** that is equipped with a sixth quick connect valve **1188** configured to mate with the fifth quick connect valve **1184,** thereby facilitating detachment of the sealable container **1110** from the source of purge gas **1182.** The sealable container **1110** is thus configured for ready attachment and detachment from the source of XeF₂ vapor **1105,** the vacuum pump **1140** and the source of purge gas **1182.** The XeF₂ etching system **1100** is also equipped with a control valve **1190** on the purge line **1180** that can be manipulated as desired to control the flow of the purge gas. The control valve **1190** is shown in communication with the system control computer **1170.**

After detachment, the sealable container **1110** is configured to facilitate movement relative to the other parts of the etching system **1100** (including the source of XeF₂ vapor **1105,** the vacuum pump **1140** and the source of purge gas **1182)** because it is relatively small and thus easy to pick up and carry. To facilitate movement, the portable etching chamber preferably weighs about 100 kilograms or less, more preferably about 20 kilograms or less. Preferably, the portable etching chamber weighs between about 5 kilograms and about 75 kilograms, more preferably between about 10 kilograms and about 50 kilograms. Other sizes may also be suitable. Other methods for facilitating movement include wheels (including rolling devices such as casters, rollers, etc.), sliding surfaces, and handles on the sealable container **1110.**

Preferably, the XeF₂ etching system **1100** further comprises a detector **1175** configured to detect a color change on the interferometric modulator substrate **1123,** where the color change is indicative of the extent of XeF₂ etching. The detector **1175** may be within the portable XeF₂ etching chamber **1110** (not shown in Figure 11) or may be placed on the exterior of the chamber **1110** near a chamber window **1185** (e.g., as described above). The detector **1175** may comprise a fiber optic bundle as described above. The computer **1170** may be operably connected to the detector to allow the computer **1170** to control one or more etching steps by monitoring the color change. Such control of etching steps is described in greater detail below. A color change may occur, for example, as etching proceeds to open a cavity between two electrodes on an interferometric modulator substrate, or on a portion of the MEMS substrate that functions as a test coupon.

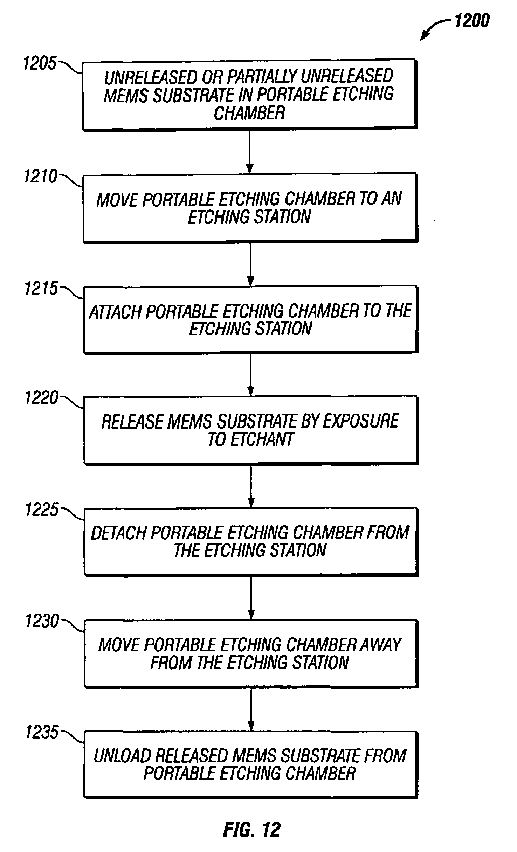

Another embodiment provides a method for etching a MEMS substrate, comprising inserting a MEMS substrate into a portable etching chamber, moving the portable etching chamber to a location in operable proximity to a source of etchant, attaching the portable etching chamber to the source of etchant, and exposing the MEMS substrate to the etchant for a period of time that is effective to etch the MEMS substrate. An embodiment of a method for etching a MEMS substrate is illustrated in the context of the process flow shown in Figure 12. The process flow **1200** begins at step **1205** by inserting a MEMS substrate into a portable etching chamber. Examples of suitable portable etching chambers include the portable XeF₂ etching chamber described above. The MEMS substrate may be an unreleased or partially unreleased interferometric modulator substrate that has been formed by a series of prior deposition, patterning and etching steps. Interferometric modulators tend to be more susceptible to damage after release, and thus release is often conducted near the end of the fabrication process in order to reduce the potential for damage. The inserting of the MEMS substrate into the portable etching chamber at step **1205** is preferably conducted soon after the previous processing step. In alternative embodiments, the inserting of the MEMS substrate into the portable etching chamber at step **1205** is conducted after attaching the portable etching chamber to the source of etchant at step **1215.** Preferably, multiple unreleased or partially unreleased MEMS substrates are placed into the portable etching chamber at step **1205.**

The process flow continues at step **1210** by moving the portable etching chamber (containing the MEMS substrate) to a location in operable proximity to an etching station that comprises a source of etchant. The distance moved may be at least about 10 meters, at least about 100 meters, or at least about one kilometer, as needed. For example, the unreleased MEMS substrate may be fabricated and loaded at step **1205** at a first factory, then moved a significant distance to a second factory at step **1210,** or moved from a prior process station to the etching station within the same factory. The MEMS substrate may also be stored in the portable etching chamber for periods of time before, during or after moving, e.g., at least about one hour, at least about one day, etc., as needed. Preferably, the portable etching chamber is substantially sealed during storage and/or movement to protect the MEMS substrate from contamination. The portable etching chamber may be moved multiple times or stored in various places, as needed. After moving, the portable etching chamber is positioned in operable proximity to the etching station (equipped with a source of etchant), e.g., so that feed lines between the etchant and portable etching chamber may be safely attached.

The process flow continues at step **1215** by attaching the portable etching chamber to the source of etchant. Such attachment is preferably made using quick connect valves or other suitable connectors known to those skilled in the art. After attachment, the portable etching system and etch source may be components of an etching system **1100** as described above and illustrated in Figures 9 and 11. The process flow continues at step **1220** by exposing the MEMS substrate **1123** to the etchant for a period of time that is effective to etch the MEMS substrate. For example, the pressure in the portable etching chamber **1110** may be lowered by attaching it to the vacuum source **1140** associated with the source of etchant **1105,** thus drawing the etchant into the portable etching chamber. In the case of an unreleased interferometric modulator substrate and a XeF₂ etchant, typical exposure times for removal of the sacrificial layer are often in the range of about 1 to about 30 minutes, more typically in the range of about 10 to 20 minutes. Exposure times may be determined by using a detector 1175 that detects a color change on the interferometric modulator substrate, e.g., a color change that results when the sacrificial material is removed and an optical cavity is formed.

The portable etching chamber and the source of etchant may be components of a XeF₂ etching system, preferably a XeF₂ etching system as described above that comprises a computer operably connected to the system and programmed to control one or more stages of the etching process. For example, in the context of the process flow illustrated in Figure 12 and the XeF₂ etching system **1100** illustrated in Figure 11, a computer **1170** is preferably operably connected to the valves **1162, 1165, 1190** that control the XeF₂ feed, vacuum, and gas purge lines, respectively. Thus, for example, the computer **1170** may be programmed to open the valve **1165** to reduce the pressure in the sealable container **1110,** e.g., to a pressure in the range of about 20 mTorr to 0.2 Torr, then close or partially close the valve **1165** and open the valve **1190,** thereby drawing purge gas (e.g., nitrogen) into the sealable container **1110** from the purge gas source **1182.** The computer **1170** may be programmed to then close the purge gas control valve **1105** and open the vacuum control valve **1165** to remove the purge gas. Purging, which is optional, may be repeated if desired.

The computer **1170** may be programmed to then close or partially close the valve **1165** and open the valve **1162,** thereby drawing XeF₂ vapor into the sealable container **1110** (having a reduced internal pressure) from the source of XeF₂ vapor **1105.** The valve **1162** may then be closed or partially closed as the XeF₂ vapor etches the interferometric modulator substrate during step **1220.** The pressure in the sealable container **1110** during etch is preferably in the range of about 0.4 to about 4 Torr and the temperature is preferably in the range of from about 20°C to about 60°C. The sealable container **1110** may be equipped with heating elements (and corresponding power connections, not shown) if heating is desired, or the XeF₂ etching system **1100** may be equipped with heating elements (not shown) configured to heat the portable etching chamber. The computer **1170** may be programmed to expose the interferometric modulator substrate to the XeF₂ vapor for a predetermined period of time, or may be programmed to monitor the output of a detector **1175** that monitors that detects a color change on the interferometric modulator substrate **1123** through a window **1185** in the sealable container **1110,** or may be programmed to wait until an operator determines that the interferometric modulator substrate has been etched sufficiently (e.g., by visually observing a color change through the window **1185** or by monitoring the output of the detector **1175).** The computer **1170** may then be programmed to open the valve **1165** to draw etching reaction by-products (and any remaining XeF₂ vapor) from the sealable container **1110.** Optionally, the computer **1170** may be programmed to purge the sealable container **1110** with inert gas in the general manner described above to sweep away the etching reaction by-products (and any remaining XeF₂ vapor).

The process flow illustrated in Figure 12 may be continued at step **1225** by detaching the portable etching chamber from the source of etchant and further continued at step **1230** by moving the portable etching chamber away from the etching station to the next step in the overall process for making the MEMS device. In the illustrated embodiment, the released MEMS substrate is unloaded from the portable etching chamber at step **1235** in preparation for further processing. In an alternative embodiment, the released MEMS substrate is unloaded from the portable etching chamber at step **1235** prior to detaching the portable etching chamber from the source of etchant at step **1225.** The released MEMS substrate may be stored and/or subjected to various further processing steps. For example, after etching and release, the MEMS substrate may be encapsulated (e.g., by depositing a capping layer) to prevent contamination of the newly formed optical cavity. The portable etching chamber may be used as a storage container and/or carrier for the released MEMS substrate prior to such additional processing steps.

The process flow illustrated in Figure 12 may thus provide significant advantages by providing a safe and convenient way to transport and store the unreleased MEMS substrate prior to etching and the released MEMS substrate after etching; increasing the flexibility and efficiency of the manufacturing process by decoupling the storage and movement of the MEMS substrate from the source of XeF₂ vapor; and increasing the scaleability of the manufacturing process by providing the ability to attach various numbers of portable etching chambers to the source of XeF₂ vapor, as needed. The illustrated process flow may also materially speed production by eliminating a load and/or unload step at the XeF₂ chamber prior to etch, relative to the use of conventional carriers or cassettes. The elimination of a load and/or unload step may also reduce the potential for substrate contamination, particularly between fabrication and release. For example, the portable etching chamber (containing one or more released MEMS substrates) could be moved from the fabrication facility to a packaging area or facility (which is typically less clean than the fabrication area or facility) without exposing the released MEMS substrates to the environment until just prior to packaging. Alternatively, release could be conducted by connecting the portable etching chamber (containing one or more released MEMS substrates) to an etching chamber located in the packaging area or facility, thereby reducing potential damage to the more fragile released substrate during movement. The portable etching chamber may also provide a safe and convenient way to store and/or transport released MEMS substrate(s) after etching.

Those skilled in the art will appreciate that the systems described above may comprise multiple etching chambers, and that multiple chambers may be attached to the system at the same time. Thus, production may be scaled up or down relatively easily by changing the number of chambers attached to the other parts of the system. Multiple chambers may also be attached serially, and the chambers that are not attached to the system at any particular time may be used to safely store and/or transport the MEMS substrates.

Another embodiment provides a portable XeF₂ etching chamber configured to contain at least one MEMS substrate and configured to contain a quantity of solid XeF₂ that is effective to etch the at least one MEMS substrate. For example, the interior of the portable XeF₂ etching chamber 700 may contain a compartment that is sized to contain the required amount of solid XeF₂. The compartment may contain small holes that permit passage of XeF₂ from the small compartment into the remainder of the chamber. Alternatively, a canister containing solid XeF₂ and having similarly sized holes may be placed into the chamber. Alternatively, the canister may be pressurized to maintain most of the solid XeF₂ in solid form within the canister until it is placed into the chamber and actuated to release an effective amount of XeF₂ within the chamber.

Another embodiment provides a XeF₂ etching system comprising a portable XeF₂ etching chamber configured to contain at least one MEMS substrate and configured to contain a quantity of solid XeF₂ that is effective to etch the at least one MEMS substrate, wherein the system is configured to feed solid XeF₂ into the portable XeF₂ etching chamber. The system preferably comprises a pressure gauge, vacuum pump, electrical lines, etc. as shown in Figure 9, a XeF₂ solids feeder, and further preferably comprises a computer operably connected to the system and programmed to control one or more stages of the etching process in a manner similar to that described above. Preferably, the system further comprises a detector configured to detect a color change on the interferometric modulator substrate, where the color change is indicative of the extent of XeF₂ etching. The computer may be operably connected to the detector to allow the computer to control one or more etching steps by monitoring the color change.

While the above detailed description has shown, described, and pointed out novel features of the invention as applied to various embodiments, it will be understood that various omissions, substitutions, and changes in the form and details of the device or process illustrated may be made by those skilled in the art without departing from the spirit of the invention. As will be recognized, the present invention may be embodied within a form that does not provide all of the features and benefits set forth herein, as some features may be used or practiced separately from others.

## Claims

1. An etching system comprising:
means for containing a MEMS substrate comprising a means for supporting at least one MEMS substrate within the containing means during movement of the containing means; and
means for attaching the containing means to at least one source selected from a XeF₂ vapor source, a vacuum source and a purge gas source, the containing means being configured to detach from the at least one source and being configured to facilitate movement relative to the at least one source.

2. The etching system of Claim 1, further comprising an etch station.

3. The etching system of Claim 1, wherein the containing means comprises a sealable container.

4. The etching system of Claim 1 or 3, wherein the attaching means comprises an inlet.

5. The etching system of Claim 1, wherein the at least one source comprises a vacuum source.

6. The etching system of Claim 1, wherein the at least one source comprises a XeF₂ vapor source.

7. The etching system of Claim 1, wherein the at least one source comprises a purge gas source.

8. The etching system of Claim 1, 3, or 4, wherein the supporting means comprises a holder.

9. The etching sytem of Claim 8, wherein the holder is configured to support an interferometric modulator substrate.

10. The etching system of Claim 9 further comprising a detector configured to detect a color change on the interferometric modulator substrate, the color change being indicative of the extent of XeF₂ substrate etching.

11. The etching system of Claim 10, wherein the detector comprises a fiber optic bundle.

12. The etching system of Claim 10, further comprising a light source configured to illuminate the interferometric modulator substrate to thereby produce reflected light, the detector being configured to detect the reflected light.

13. The etching system of Claim 1, further comprising a computer operably connected to the etching system and programmed to control one or more stages of an etching process.

14. The etching system of Claim 13, wherein the computer is programmed to receive input from a detector.

15. The etching system of Claim 14, wherein the detector is configured to detect a color change on the interferometric modulator substrate.

16. The etching chamber of Claim 1, wherein said means for containing is portable.

17. The portable etching chamber of Claim 16, wherein the containing means comprises a sealable container, and the attaching means comprises an inlet configured for attachment to the at least one source.

18. The portable etching chamber of Claim 17, wherein the at least one source comprises a purge gas source.

19. The portable etching chamber of Claim 17, wherein the at least one source comprises a vacuum source.

20. The portable etching chamber of Claim 17, wherein the at least one source comprises a XeF₂ vapor source.

21. The portable etching chamber of Claim 17, wherein the sealable container is configured to contain a quantity of solid XeF₂ that is effective to etch the at least one MEMS substrate.

22. The portable etching chamber of Claim 17, wherein the supporting means comprises a holder configured to support the at least one MEMS substrate within the sealable container during movement of the sealable container.

23. The portable etching chamber of Claim 22, wherein the holder is configured to support an interferometric modulator substrate.

24. The portable etching chamber of Claim 23, wherein the sealable container further comprises a window configured to facilitate observation of the interferometric modulator substrate from the exterior of the sealable container.

25. The portable etching chamber of Claim 24, wherein the window is configured to facilitate detection of a color change on the interferometric modulator substrate, where the color change is indicative of the extent of XeF₂ etching.

26. The portable etching chamber of Claim 16, wherein the supporting means comprises at least two supports positioned on opposite sides of the MEMS substrate.

27. The portable etching chamber of Claim 16, wherein the containing means comprises a container, the container comprising a door and at least one seal in contact with the door, the seal and door being configured to substantially prevent XeF₂ vapor from escaping the container.

28. The portable etching chamber of Claim 27, wherein the supporting means comprises at least one slot on a wall of the container.

29. The portable etching chamber of Claim 16 wherein the at least one source comprises a XeF₂ vapor source.

30. The portable etching chamber of Claim 29, wherein the attaching means comprises a quick connect valve.

31. The portable etching chamber of Claim 16 further comprising means for moving the portable etching chamber.

32. The portable etching chamber of Claim 31, wherein the moving means comprises at least one selected from a wheel, a substantially low-friction sliding surface, and a handle.

33. The portable etching chamber of Claim 32, wherein the wheel comprises a roller.

34. The portable etching chamber of Claim 32, wherein the wheel comprises a caster.

35. A method of etching a MEMS substrate, comprising:
moving a portable etching chamber to a location in operable proximity to a source of etchant;
attaching the portable etching chamber to the source of etchant;
exposing a MEMS substrate supported in the portable chamber to the etchant for a period of time that is effective to etch the MEMS substrate to form a released MEMS substrate;
detaching the portable etching chamber from the source of etchant;
moving the portable etching chamber away from the source of etchant; and
unloading the released MEMS substrate from the portable etching chamber.

36. The method of Claim 35 further comprising inserting the MEMS substrate into the portable etching chamber prior to attaching the portable etching chamber to the source of etchant.

37. The method of Claim 35, wherein the portable etching chamber comprises a sealable container comprising an inlet configured for attachment to the source of etchant and a holder configured to support the MEMS substrate within the sealable container.

38. The method of Claim 35, wherein the etchant comprises XeF₂ vapor.

39. The method of Claim 38, wherein the MEMS substrate is a partially fabricated interferometric modulator.

40. The method of Claim 35, wherein the portable etching chamber comprises wheels.

41. The method of Claim 40, wherein the step of moving the portable etching chamber comprises rolling the wheels along a surface.

42. The method of Claim 35, wherein the step of moving the portable etching chamber comprises lifting the portable etching chamber.

43. The method of Claim 35, wherein the portable etching chamber weighs about 20 kilograms or less.

44. The method of Claim 35, wherein the portable etching chamber weighs about 100 kilograms or less.

45. The method of Claim 36, wherein, after the step of inserting the MEMS substrate into the portable etching chamber, the MEMS substrate is stored in the portable etching chamber for at least about one hour prior to the step of attaching the portable etching chamber to the source of etchant.

46. The method of Claim 36, wherein, after the step of inserting the MEMS substrate into the portable etching chamber, the MEMS substrate is stored in the portable etching chamber for at least about one day prior to the step of attaching the portable etching chamber to the source of etchant.

47. The method of Claim 35 further comprising attaching the portable etching chamber to a vacuum pump.

48. The method of Claim 35, wherein the step of moving the portable etching chamber comprises transporting the portable etching chamber a distance of at least about 10 meters.

49. The method of Claim 48, wherein the distance is at least about 100 meters.

50. The method of Claim 48, wherein the distance is at least about one kilometer.

51. The method of Claim 35, wherein the MEMS substrate is exposed to the etchant for a period of time that is effective to fully release the MEMS substrate.

52. The method of Claim 35 further comprising unloading the released MEMS substrate from the portable etching chamber prior to moving the portable etching chamber away from the source of etchant.

53. The method of Claim 35 further comprising unloading the released MEMS substrate from the portable etching chamber after detaching the portable etching chamber from the source of etchant.

54. The method of Claim 35 further comprising unloading the released MEMS substrate from the portable etching chamber after moving the portable etching chamber away from the source of etchant.

55. The method of Claim 35 further comprising inserting the MEMS substrate into the portable etching chamber after attaching the portable etching chamber to the source of etchant.

56. The method of Claim 35, wherein the MEMS substrate is housed within the portable etching chamber during the moving of the portable etching chamber to a location in operable proximity to the source of etchant.

57. An etched MEMS substrate formed by the method of any one of Claims 35 to 56.
